# EUROPEAN PATENT APPLICATION

(11) **EP 4 663 356 A1**
(43) Date of publication of application: **17.12.2025**
(21) Application number: 25181006.5
(22) Date of filing: 05.06.2025
(51) Int. Cl.: B25J 9/16, B25J 15/00, B25J 15/06, B65G 47/91, H01L 21/683

(54) **CONTROL METHOD FOR CONTROLLING AN ARTICLE HANDLING SYSTEM**

(30) Priority: 10.06.2024 IT 202400013195
(71) Applicant: Gaiotto Automation S.p.A., 40026 Imola (IT)
(72) Inventor: GAMBAZZA, Mattia, 40026 Imola (BO) (IT)
(74) Representative: Studio Torta S.p.A.

(57) **Abstract**

A control method for controlling a handling system (1) comprising a support structure (4) carrying a gripping device (5) which, in turn, comprises a suction chamber (6), a vacuum generating unit (8), a gripping surface (9), and a plurality of valve assemblies (11), each provided with a duct (13), a shutter (14) movable in the respective duct (13) between a first position and a second position to prevent or enable the fluidic connection between the duct (13) and the suction chamber (6), and a compensation hole (15); the method comprises: tilting the gripping device (5) with respect to the horizontal direction to conduct the shutter (14) towards the first position; activating the generating unit (8) so as to exert a first suction action on the shutter element (14), in order to hold the same in the first position; and bring the gripping surface (9) into contact with the article (3) to be picked up so as to bring the shutter (14) into the second position and transmit the gripping action to the article (3).

## Description

### CROSS-REFERENCE TO RELATED APPLICATIONS

This patent application claims priority from Italian patent application no. 102024000013195 filed on June 10, 2024, the entire disclosure of which is incorporated herein by reference.

### TECHNICAL FIELD

The present invention relates to a control method for controlling a handling system and to a handling method for moving articles by means of a vacuum gripping device, particularly suitable for handling substantially flat articles or polyhedral articles.

### BACKGROUND OF THE INVENTION

Commonly known in the field of article logistics is the use of automated vacuum depression handling systems, so-called pick and place, for the transport and handling of substantially flat articles or at least partially polyhedral articles, namely, having at least one substantially flat surface.

Known automated handling systems generally comprise: a support and handling structure with one or more axes, typically formed by an anthropomorphic robot or a Cartesian robot, a vacuum depression gripping device that is carried by the support structure and, in turn, comprises: at least one suction hood; a vacuum generation system that can be operated to generate a vacuum inside the suction hood; and a gripping surface (formed, for example, by an array of suction cup or a suction plate) that extends from the suction hood, on the opposite side to the vacuum generation system, and is capable of coming into contact with the article to be picked up in order to grasp and keep the same in the grip during the various handling operations. In more detail, said vacuum gripping devices, due to the action of the vacuum generation system, are able to exert on the article to be picked up a suction force sufficient to hold the article to be moved and keep the same in position during handling.

However, said well-known systems, although being used effectively for several years, have some technical disadvantages, especially when used in fields that require high flexibility in terms of shape and size of the articles to be handled, as they risk being ineffective when the articles to be handled have dimensions much smaller than the dimensions of the gripping surface.

In these cases, in fact, there is a risk that pressure is lost due to the entry of air into the suction hood through the areas of the gripping surface that, in use (namely, when gripping the article), are not occupied by the article to be handled, determine a drop in the vacuum depression in the suction hood thus reducing the suction force exerted on the article to be picked up and, in the most serious cases, lead to the loss of the grip.

To avoid said risk, it is known to manually apply a removable covering layer, typically made of adhesive felt, at the areas of the gripping surface that exceed the size of the article to be handled or, in more modern systems, to provide self-closing valves arranged between the suction hood and the gripping surface at each hole of the gripping surface (when the latter is part of a suction plane), or at each suction cup (in the case of a gripping surface formed by an array of suction cups), and configured to close automatically by aerodynamic effect when the vacuum generation system is active and the corresponding hole, or the corresponding suction cup, is not in contact with an article to be picked up.

In particular, the well-known self-closing valves are normally open to enable the fluidic connection between the suction hood and the outside environment, through the holes or suction cups, and they close automatically, thus preventing the fluidic connection between the suction hood and the outside environment due to the aerodynamic effect when there is a given depression value inside the suction hood (therefore the vacuum generator is active) and a given flow rate of air (variable based on the type of vacuum generator and the volume of the suction hood) enters, through the hole or the suction cup, into the valve itself.

However, even these handling systems provided with self-closing valves have limitations and risk becoming ineffective when the article to be picked is very small. In fact, handling systems of this type are generally sized to operate effectively when at least half of the gripping surface, more typically at least 70% of the gripping surface, is occupied by the article to be picked up. Otherwise, in fact, the degree of depression generated by the vacuum generator is not sufficient to determine the automatic closing of the self-closing valves that remain not occluded by the article to be picked up, unless the handling systems are provided with very powerful vacuum generators with the disadvantage of high pressure drops in all passage sections. Furthermore, the use of vacuum generators sized to operate even with more than half of the gripping surface unoccupied/occluded would lead to an inevitable increase in the costs and dimensions of the handling system.

The purpose of the present invention is to propose a control method for controlling an article handling system and a handling method for moving articles, which enable to overcome, at least partially, the drawbacks of the prior art and are, at the same time, easy and inexpensive to implement.

### SUMMARY

According to the present invention, a control method for controlling an article handling system and a handling method for moving articles is proposed, as set out in the independent claim that follows and, preferably, in any of the claims dependent directly or indirectly on the independent claim.

The claims describe preferred embodiments of the present invention and form an integral part of the present description.

### BRIEF DESCRIPTION OF THE FIGURES

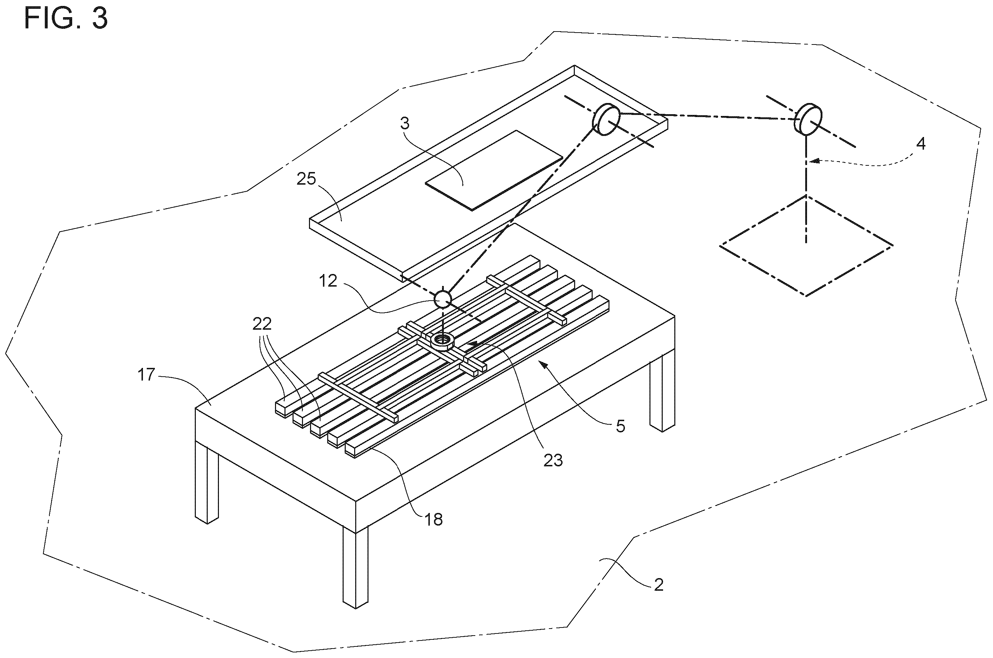

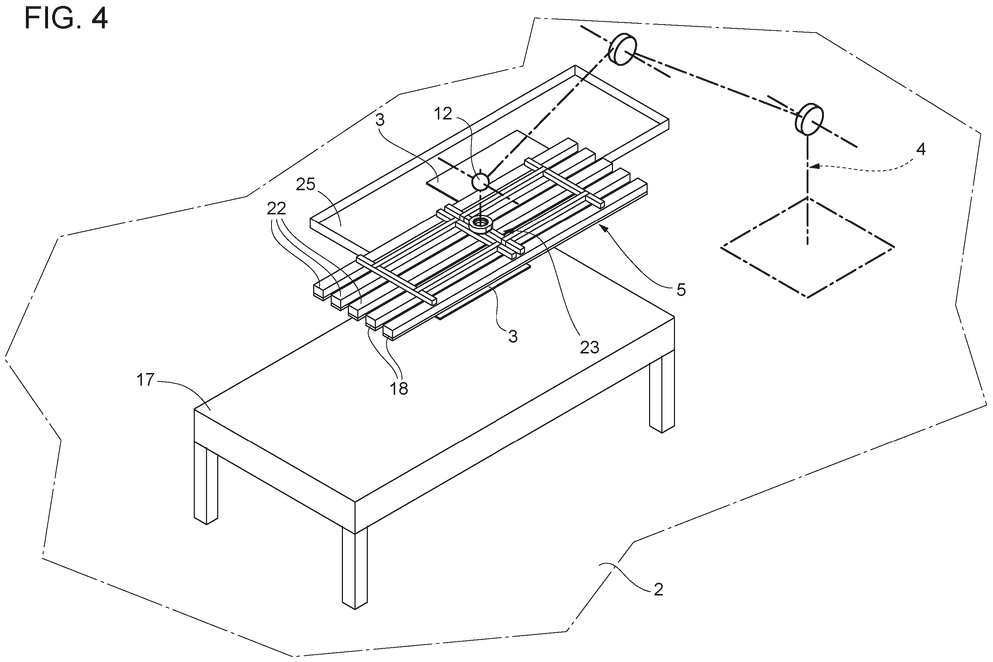

For a better understanding of the present invention, some embodiments are now described, purely by way of non-limiting example, with reference to the attached drawings, wherein:

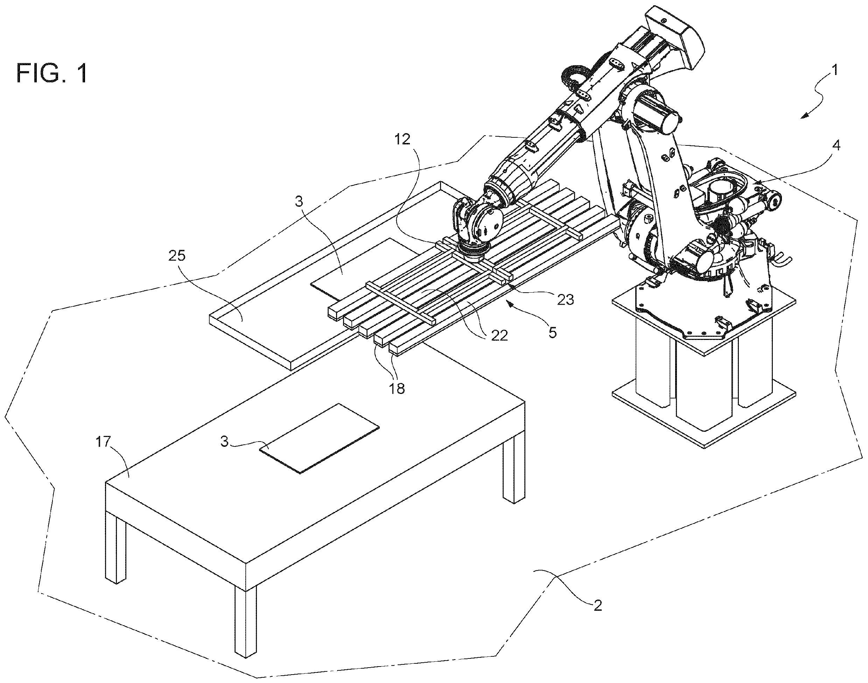

- Figure 1 schematically illustrates a handling system, made according to a possible embodiment of the present invention, a support that carries an article to be moved and a lateral bench that carries an article;
- Figures from 2 to 4 are schematic representations of the handling system of Figure 1 during the successive steps of the handling method of the present invention, during which, respectively, the handling system prepares to pick up the article arranged on the support of Figure 1 (see Figure 2), the handling system comes into contact with the article to be picked up (see Figure 3), and the same handling system picks up the article 3 from the support to carry it towards the bench;

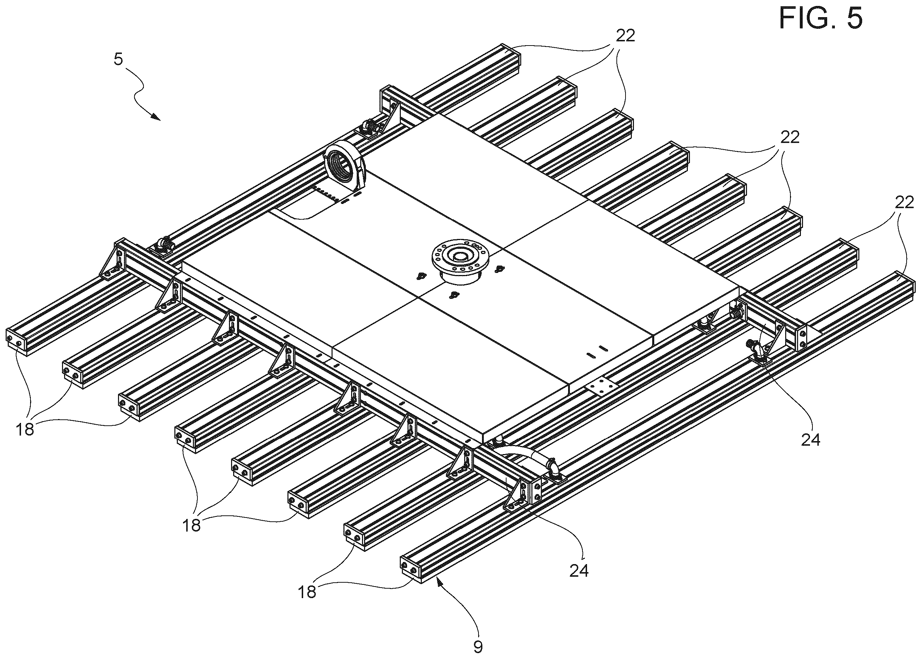

- Figure 5 is a perspective view of a gripping device that is part of the handling system of the previous figures according to the first embodiment of the present invention;

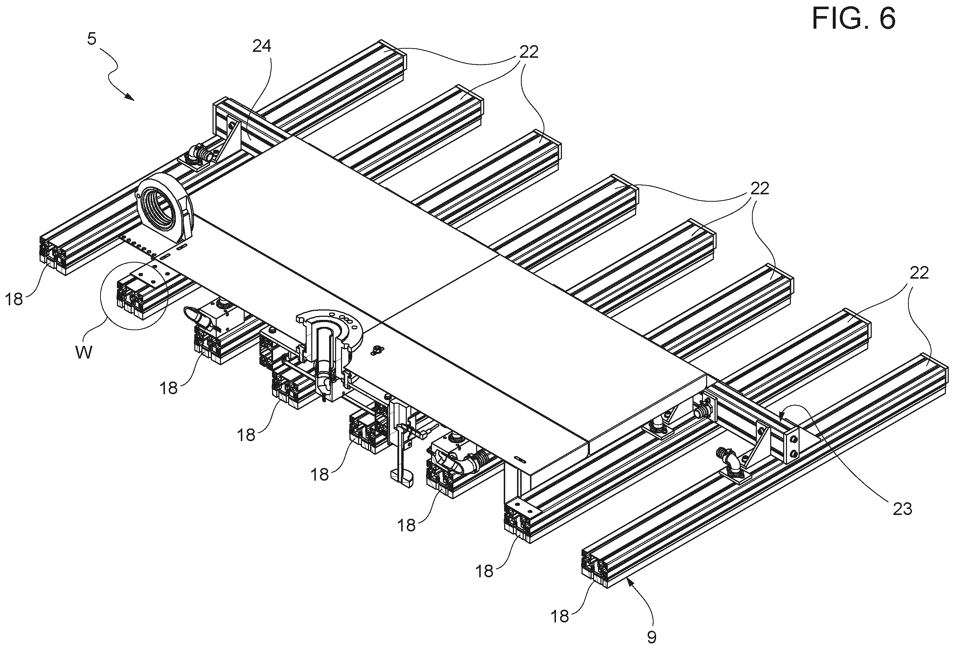

- Figure 6 is a sectional view of the gripping device of Figure 5;

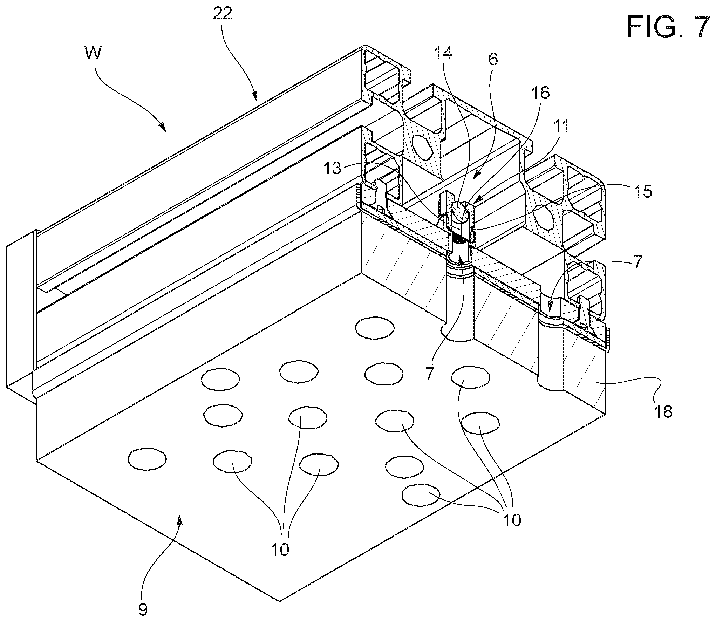

- Figure 7 is an enlarged scale view of the detail W of Figure 6 seen from another angle to better illustrate some parts of the same;

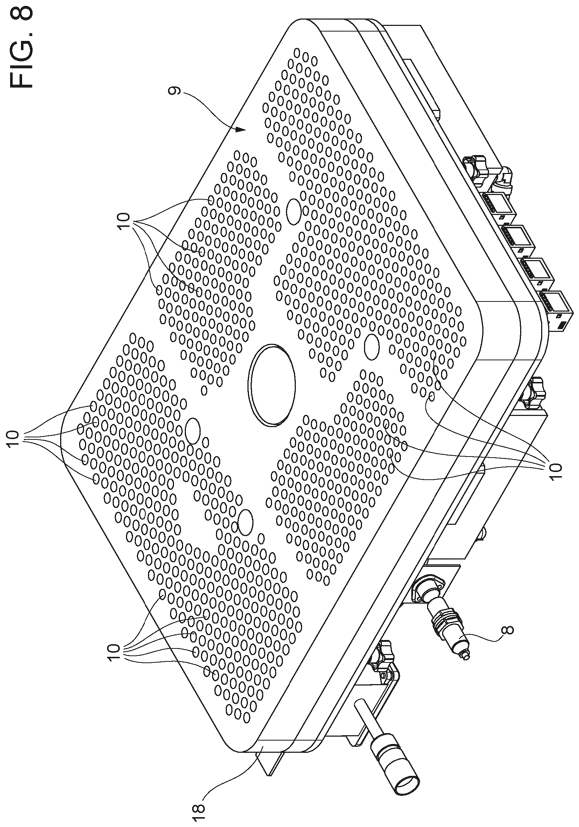

- Figure 8 is a perspective view of a gripping device that is part of the handling system according to a further embodiment of the present invention;

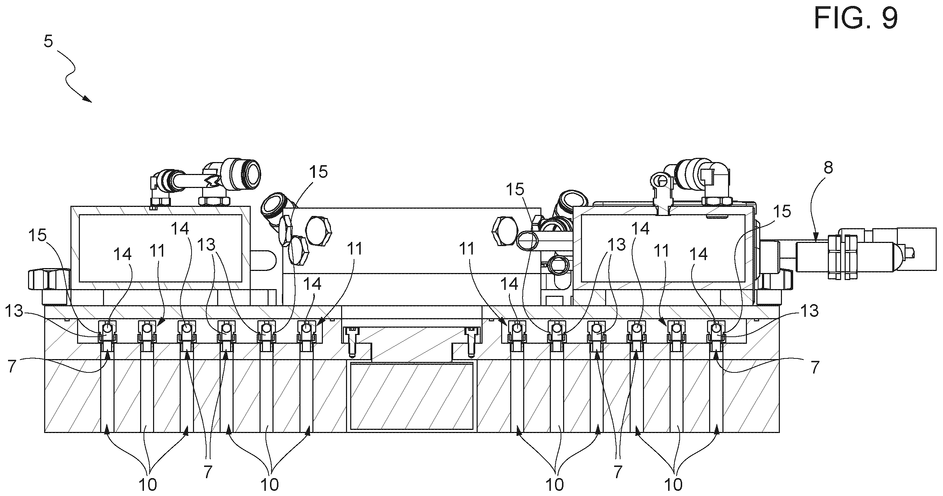

- Figure 9 is a sectional view of the gripping device of Figure 8;

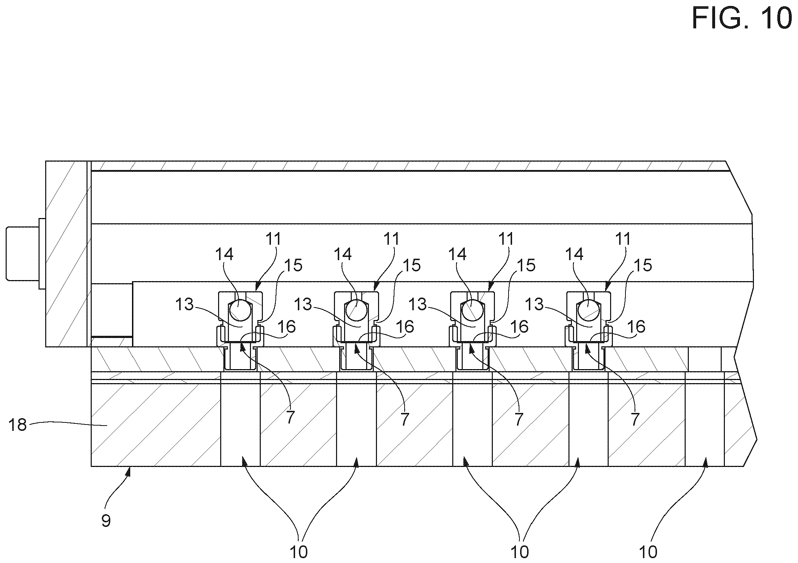

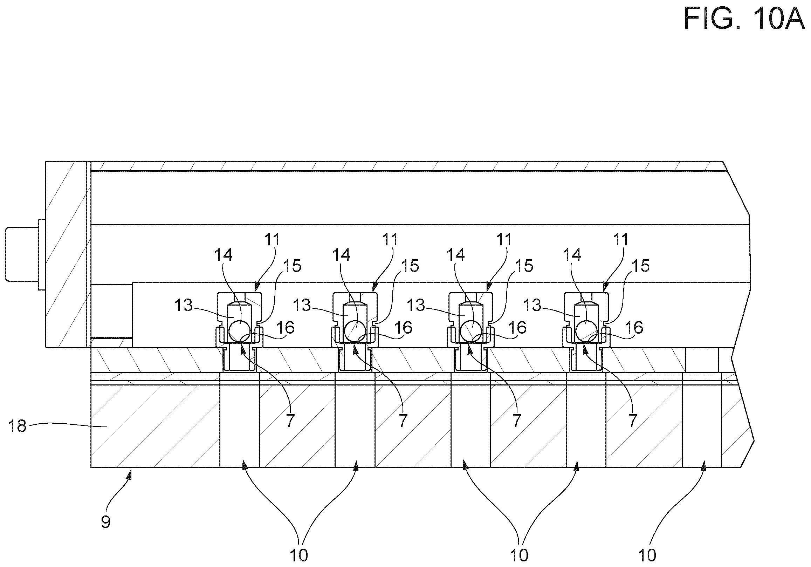

- Figure 10 is an enlarged view of part of the section of Figure 9 to better illustrate some parts;
- Figure 10A represents the same part of the section of Figure 9 illustrated in Figure 10 in another operating configuration;

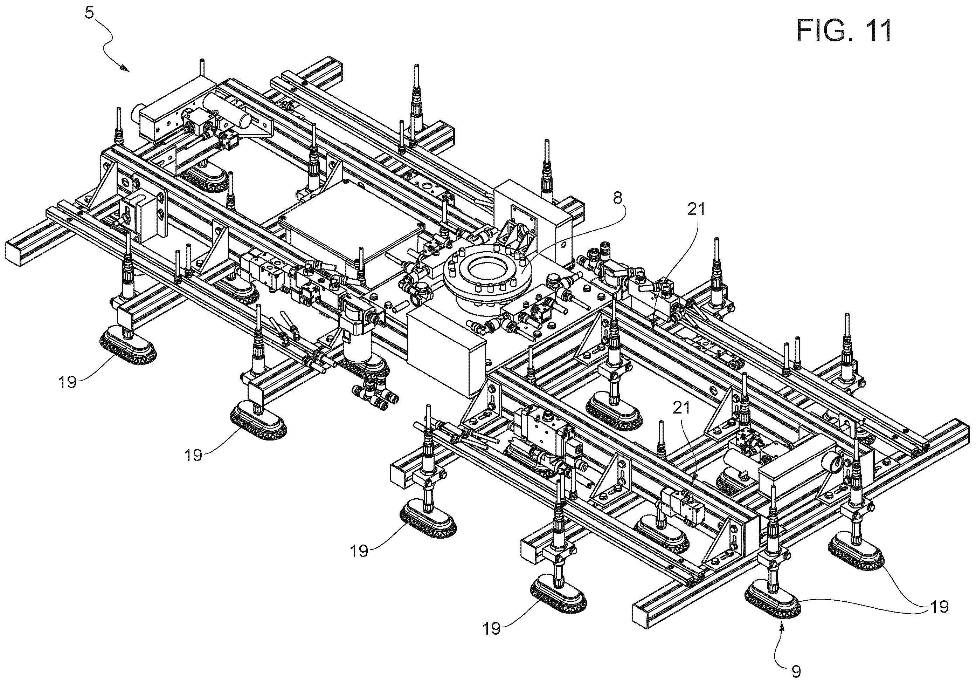

- Figure 11 is a perspective view of a gripping device that is part of the handling system according to yet another possible embodiment of the present invention; and

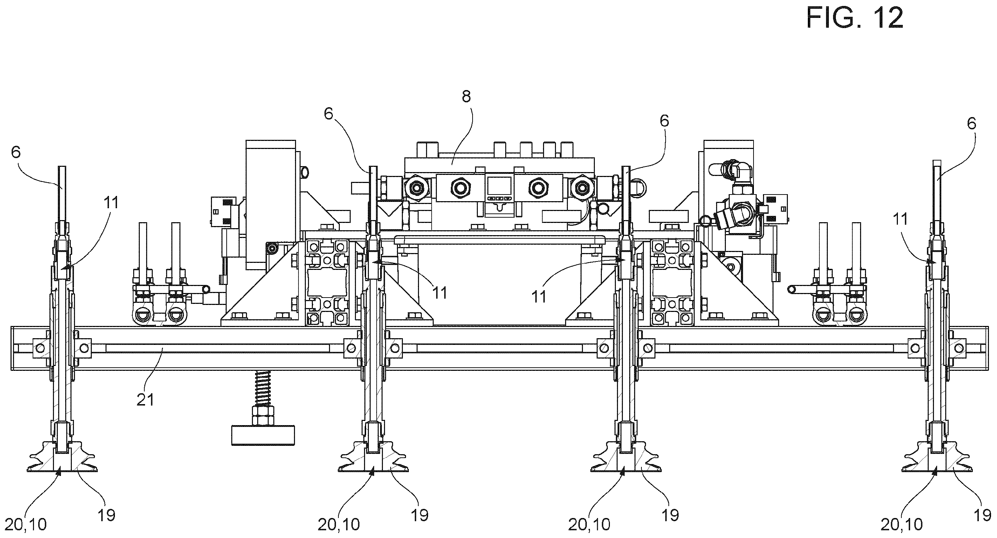

- Figure 12 is a sectional view of the gripping device of Figure 11.

### DETAILED DESCRIPTION

In the attached figures with the reference 1, a handling system used to implement the handling method of the present invention is indicated as a whole.

In particular, the present disclosure will make particular reference to the handling of substantially flat articles 3 or articles 3 that are at least partially polyhedral (more specifically, having at least one substantially flat wall). Even more specifically, advantageously but not limitingly, in the following of the present disclosure, particular reference will be made to the handling of substantially flat ceramic articles 3, for example ceramic slabs or tiles, taken individually or organised in assemblies, the so-called "tile squares(quadrotte)" of ceramic articles, without thereby losing generality.

It should be noted that in the context of the present description, the term "second" element does not imply the presence of a "first" element. Said terms are, in fact, used as labels to improve clarity and should not be considered in a limiting manner. Furthermore, terms such as "upper", "lower", "height", "measurement" etc. are used with reference to the handling system 1 arranged on a substantially horizontal support plane 2, for example on the ground or on the floor, on which the article 3 to be picked up is also, directly, or indirectly, arranged.

Advantageously, the handling system 1 used to implement the article handling method 3 of the present invention is of the vacuum depression (vacuum) type and even more advantageously but not limitingly comprises: a support structure 4 that can be moved in space and a vacuum gripping device 5 that is movable by the support structure 4.

Advantageously, the vacuum gripping device 5, in turn, comprises: a suction chamber 6 provided with a plurality of first openings 7, a vacuum generating unit 8 that can be operated to generate a given vacuum in the suction chamber 6; a gripping surface 9 intended, in use, to come into contact with the article 3 to be picked up and provided with a plurality of second openings 10, advantageously but not limitingly counter-facing the first openings 7, and a plurality of valve assemblies 11 operatively interposed between the suction chamber 6 and the gripping surface 9.

Advantageously but not limitingly, the value of the aforementioned given depression (generated by the vacuum generating unit 8 inside the suction chamber 6) varies, at least as a function of the size of the gripping surface 9 and/or the type of article 3 to be picked up, approximately from at least -0.1 bar to approximately -0.3 bar; more advantageously it is equal to approximately -0.2 bar.

According to some advantageous but not limiting embodiments such as, for example, the one illustrated in Figure 1, the support structure 4 comprises (in particular, is formed by) a robot with five degrees of freedom and is configured to enable the movement of the vacuum gripping device 5 in three mutually orthogonal directions and to rotate the vacuum gripping device 5 with respect to the support structure 4 around at least two rotation axes, perpendicular to one another.

Even more advantageously but not limitingly, according to some embodiments, for example the one illustrated in Figure 1, the support structure 4 comprises (in particular, is formed by) an anthropomorphic robot, known per se and not described in detail herein.

According to other advantageous but not limiting and not illustrated embodiments, the support structure 4 comprises (in particular, is formed by) a Cartesian robot, known per se.

More advantageously but not limitingly, according to some embodiments such as, for example, the one illustrated in Figure 1, the handling system 1 comprises a spherical joint 12 interposed between the support structure 4 and the vacuum gripping device 5.

Advantageously, each valve assembly 11 comprises a duct 13 that extends from a respective first opening 7 to a respective second opening 10, a shutter 14 that is movable in the respective duct 13 between a first position, in which it occludes the respective first opening 7 to prevent the fluidic connection between the respective duct 13 and the suction chamber 6 (see for example Figures 9 and 10), and a second position (see Figure 10A), in which it disengages, at least partially, the opening 7 to enable the fluidic connection between the respective duct 13 and the suction chamber 6 through the respective first opening 7, and a compensation hole 15 (namely, a controlled leak hole 15) that connects the duct 13 to the suction chamber 6.

The presence of the compensation hole 15 advantageously ensures the automatic opening of the valve assembly 11 when the opening 10 that delimits the duct 13 of said valve assembly 11 is occluded by the article 3 to be removed. In particular, once the vacuum generating unit 8 is activated, a controlled flow of fluid (in particular, air) is established between the suction chamber 6 and the duct 13 (more advantageously, from the suction chamber 6 towards the duct 13) which is, in fact, irrelevant when the opening 10 is not occluded and the pressure inside the duct 13 is substantially equal to atmospheric pressure; while it enables the establishment of pressure conditions similar to those present in the suction chamber 6, when the opening 10 is occluded thus inducing the opening of the valve assembly 11, namely, the passage of the shutter 14 from the first position to the second position, as will be better explained in the following.

Advantageously but not limitingly, the compensation hole 15 has an area approximately of at most 4 mm², in particular approximately between 1 mm² and approximately 4 mm². According to at least advantageous but not limiting embodiments, each valve assembly 11 also comprises a perforated dividing element 16, for example in the illustrated cases a grid, which extends from the duct 13 of each valve assembly 11 and is configured to receive the shutter 14, when the same is conducted towards the second opening 10. Even more advantageously but not limitingly, in this case, in the aforementioned second position the shutter 14 is arranged on the perforated dividing element 16, so as to disengage the opening 7 and, at the same time, enable the transmission of the aforementioned first suction action to the article 3 to be picked up.

Advantageously but not limitingly, the handling system 1 comprises a layer 18 made of flexible material (in particular, having an elastic modulus approximately ranging from 0.5 N/mm² to approximately 10 N/mm²) interposed between the suction chamber 6 and the gripping surface 9; the ducts 13 of the valve assemblies 11 passing through the layer 18 of flexible material (see, in particular, Figures 7, 9, 10, 10A).

Alternatively, or in addition, according to some advantageous but not limitative embodiments, such as those illustrated in Figures 5, 6 and 7, the gripping device 5 comprises (in particular, is formed by) a plurality of suction strips 22 carried by a frame 23, advantageously but not limitingly, equidistant from one another. In this way, in the event of failures, it will be sufficient to replace one or more suction strips 22, thus reducing the costs and time required for maintenance.

In particular, in this case, each of said suction strips 22 comprises, in turn: a suction chamber 6 provided with a plurality of first openings 7 and in fluidic connection with the vacuum generating unit 8, a gripping surface 9 that delimits the bottom of each suction strip 22, is intended, in use, to come into contact with the article 3 to be picked up and is provided with a plurality of second openings 10, advantageously but not limitingly counter-facing the first openings 7, and a plurality of valve assemblies 11 operatively interposed between the suction chamber 6 and the gripping surface 9.

Even more advantageously but not limitingly, each suction strip 22 comprises a pressing layer 18 made of flexible material, advantageously of the type described above, interposed between the suction chamber 6 and the gripping surface 9 and configured to absorb any roughness of the wall of the article 3 to be picked up at the time of contact so as to guarantee the stability of the grip.

More advantageously but not limitingly, the frame 23 is a telescopic frame having at least two support brackets 24, parallel to one another, and mutually movable to increase or reduce the distance between the various suction strips 22.

According to some other advantageous but not limiting embodiments, such as those illustrated in Figures 11 and 12, the gripping surface 9 comprises (in particular, is formed by) an array of suction cups 19, each having a hole 20, in communication with the opening 10, or according to other advantageous but not limiting embodiments that coincide with the opening 10. Even more advantageously but not limitingly, in this case, the vacuum gripping device 5 comprises a frame 21, advantageously but not limitingly articulated, operable to adjust the mutual distance between said suction cups 19.

With particular reference to Figures from 1 to 4, the handling method and the control method of the present invention are used to handle (in particular, for picking up and moving) an article 3 arranged on a substantially horizontal support 17 resting on the support plane 2 and parallel to the same.

Advantageously, the handling method comprises the following steps: an initial step, during which a handling system 1 of the type described above is provided, in particular a vacuum depression (or vacuum) system; a tilting step, during which the support structure 4 rotates the vacuum gripping device 5 by an angle approximately of at least 90° (in particular, by an angle approximately ranging from at least 90° to approximately 180°; more specifically, approximately equal to 110°) with respect to the support plane 2 of the support 17 (in particular, with respect to the support 17; more specifically, with respect to the horizontal direction) so that the shutter 14 of each valve assembly 11 shifts, by gravity, from the second position to the first position; an activation step, (at least partially) subsequent to the tilting step, during which the suction unit 8 generates the aforementioned specific vacuum depression (advantageously but not limitingly, approximately ranging from -0.1 bar to approximately -0.3 bar; in particular, approximately equal to -0.2 bar) inside the suction chamber 6 so as to exert a first suction action on the shutter 14, through the first opening 7, so as to hold the same in the first position; and a gripping step, during which the support structure 4 moves the vacuum depression gripping device 5 until the gripping surface 9 comes into contact with at least one wall of the article 3 to be picked up, thus occluding at least a part of the second openings 10 so as to cause the movement of the respective shutters 14 (which are arranged in the ducts 13 delimited by the aforementioned part of the second occluded openings 10) from the first position to the second position in order to transfer the aforementioned first suction action (in particular, at least part of the aforementioned first suction action) to the article 3 to be picked up so as to hold the same, during the various subsequent handling steps.

Furthermore, a control method is proposed to automatically control a handling system 1 of the type described above; the method comprises the following steps: rotating the vacuum gripping device 5 by an angle of approximately at least 90° (in particular, by an angle ranging from approximately at least 90° and approximately 180°) with respect to the support plane 2 (in particular, with respect to a horizontal plane) by operating the support structure 4 so that the shutter 14 of the various valve assemblies 11 of the handling system 1 moves, by gravity, from the second position to the first position; setting a given vacuum value, advantageously equal approximately to at least -0.1 bar, in the suction chamber 6 by means of the vacuum generating unit 8 while the support structure 4 is still rotated to exert a first suction action on the shutter 14 which maintains (in particular, holds it) in the first position; and bring the gripping surface 9 into contact with at least one wall of the article 3 to be picked up by occluding at least part of the second openings 10 so as to cause the movement of the respective shutters 14 from the first position to the second position in order to transfer the aforementioned suction action (in particular, at least part of the suction action) to the article 3 to be picked up so as to hold the same.

The method of the present invention advantageously enables a stable grip on the article 3 to be picked up even when the same has dimensions much smaller than the dimensions of the gripping plane 9 while keeping, at the same time, the costs, and dimensions of the handling system 1 comparable to those known. In fact, the presence of the tilting step, namely, the rotation of the vacuum gripping device 5 by an angle of approximately at least 90°, ensures the automatic closing of the various valve assemblies 11 before gripping the article to be picked up (namely, before the gripping step, or the step of bringing the gripping surface 9 into contact with a wall of the article 3 to be picked up) and their subsequent automatic opening when the vacuum gripping device 5 is arranged in contact with the article 3 to be picked up without the need to oversize the vacuum generating unit 8.

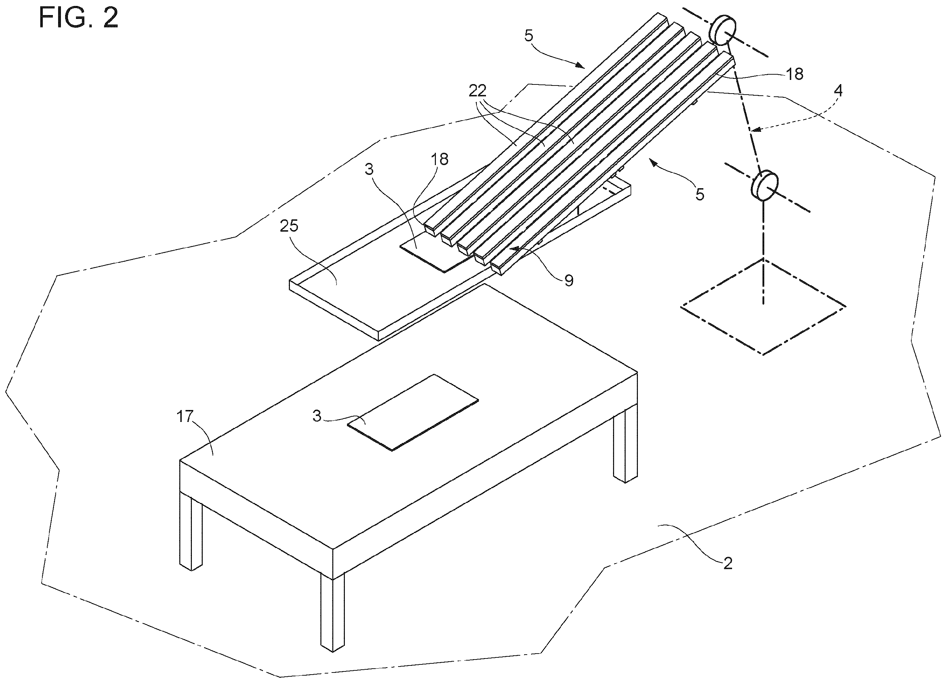

Advantageously but not limitingly, the step of rotating the vacuum gripping device 5 (in particular, also the tilting step of the handling method) comprises a first tilting sub-step, during which the vacuum gripping device 5 is moved (more advantageously, the support structure 4 moves the vacuum gripping device 5) from an initial configuration (see, for example, Figure 1) to a tilted configuration (see, for example, Figure 2), where the gripping surface 9 is arranged so as to form an angle of approximately at least 90° with respect to the support plane 2; more advantageously equal to approximately 110°, with respect to the support plane 2 and during the step of setting a given vacuum value the vacuum gripping device 5 is held in this tilted configuration at least until the aforementioned given vacuum is established inside the gripping chamber 6, advantageously but not limitingly equal to approximately at least -0.1 bar, so that the suction action transmitted to the shutter 14 through the opening 7 can hold the shutter 14 in position.

More advantageously but not limitingly, in the tilted configuration the gripping surface 9 is arranged so as to form an angle ranging from approximately at least 90° and approximately 180° with respect to the support plane 2, in particular with respect to the horizontal direction. Even more advantageously but not limitingly, in the tilted configuration the gripping surface 9 is arranged so that each second opening 10 is arranged at a distance from said support plane 2 (in particular, at a height) greater than the distance from the same support plane 2 (in particular, at the height) of the respective first opening 7.

According to some advantageous but not limiting embodiments, the aforementioned step of rotating the vacuum gripping device 5 (in particular, also the tilting step of the above-mentioned handling method) comprises a second tilting sub-step, (at least partially) subsequent to the aforementioned first tilting step, during which the vacuum gripping device 5 is held in the tilted configuration, by means of said support structure 4, for an amount of time approximately by at least 0.5 seconds; more advantageously but not limitingly, for an amount of time approximately by at least 1 second; even more advantageously but not limitingly, for an amount of time by approximately at least 2 seconds. In other words, during the second tilting sub-step the support structure 4, after having rotated the vacuum gripping device 5 to the aforementioned tilted configuration, holds said vacuum gripping device 5 in this configuration for an amount of time approximately by at least 0.5 seconds; more advantageously but not limitingly, for an amount of time approximately by at least 1 second; even more advantageously but not limitingly, for an amount of time approximately by at least 2 seconds.

Advantageously but not limitingly, the step of bringing said gripping surface 9 into contact with a wall of the article 3 to be picked up (in particular, the gripping step of the handling methods) comprises, in turn: a compensation sub-step, during which, once the second opening 10 delimiting a given duct 13 is occluded by the article 3 to be picked up, the aforementioned controlled flow of fluid established between the suction chamber 6 and the duct 13 through the compensation hole 15 continues until it induces pressure conditions inside the duct 13 similar to those present inside the suction chamber 6 so that the shutter 14 is subjected, on the side of the duct 13, to a second suction action, equal and opposite to the aforementioned first suction action; and an opening sub-step, (at least partially) subsequent to the compensation sub-step, during which the shutter 14, subjected to a resulting action directed towards the second opening 10, shifts from the first position to the second position. In particular, advantageously but not limitingly, in this opening sub-step the shutter 14 moves from the first position to the second position at least under the effect of gravity, or at least due to the force of weight.

In detail, according to some advantageous but not limiting embodiments, the shutter 14 comprises (in particular, is formed by) an element having a mass greater than approximately 0.1 g, therefore not negligible, for example a metal sphere and during the opening sub-step, the shutter 14 is subjected to the first suction action from the side of the suction chamber 6, to the second suction action from the side of the duct 13, and to the force of weight, so that (the first and second suction forces being equal and opposite) it shifts from the first position to the second position exclusively due to the effect of the force of weight.

According to other advantageous but not limiting and not illustrated embodiments, each valve assembly 11 comprises a spring arranged in the respective duct 13 and configured to act on the shutter 14, by transmitting an elastic force having at least one component along a direction parallel to a longitudinal axis of the respective duct 13; said elastic force is directed from the first opening 7 towards the second opening 10, and has a modulus (intensity) lower than the force of weight to which the shutter 14 is subjected); and during the opening sub-step the shutter 14 is subjected to the first suction action, to the second suction action, to the force of weight and to the elastic force and is pushed from the first position to the second position at least by the elastic force. This advantageously enables the effective gripping of articles 3 arranged with the wall intended to come into contact with the gripping plane 9 inclined with respect to the horizontal direction by angles approximately greater than or equal to 80° with respect to the support 17 (namely, with respect to the horizontal direction); more advantageously by angles ranging from 80° to 100° with respect to support 17 (namely, with respect to the horizontal direction); even more advantageously by angles approximately reaching up to 180° with respect to support 17 (namely, with respect to the horizontal direction).

Even more advantageously but not limitingly, when the article 3 to be picked up, or the wall of said article 3, is inclined by an angle approximately ranging between 80° and approximately 180° with respect to the support 17; more specifically, from approximately 80° to approximately 100° with respect to the support 17, during the opening sub-step the shutter 14 is pushed from the first position to the second position mainly by the spring force. While when the article 3 to be picked up, or the wall of said article 3, is inclined by an angle comprised between 0° and approximately 80° with respect to the support 17 during the opening sub-step the shutter 14 is pushed from the first position to the second position by the combined action of the spring force and the force of weight. Advantageously but not limitingly, when the gripping device 15 comprises the above-described layer 18 made of flexible material (see for example the embodiments illustrated in Figures from 1 to 10), during the step of bringing the gripping surface 9 into contact with a wall of the article 3 to be picked up (in particular, also during the gripping step of the handling method), once the gripping surface 9 has come into contact with the wall of the article 3 to be picked up, the layer 18 made of a flexible material deforms, at least partially, to compensate for (namely, absorb) any roughness of the wall of the article 3 to be picked up and ensure the stability of the grip.

Alternatively, advantageously but not limitingly, when the vacuum gripping device 5 comprises (in particular, is formed by) suction cups 19, during the step of bringing the gripping surface 9 into contact with a wall of the article 3 to be picked up (in particular, also during the gripping step of the handling method), once the gripping surface 9 has come into contact with the wall of the article 3 to be picked up, the suction cups 19 deform (namely, they flatten), at least partially, to compensate for any roughness of the article 3.

Advantageously but not limitingly, the method of the present invention comprises a handling step, (at least partially) being simultaneous with the step of bringing the gripping surface 9 into contact with a wall of the article 3 to be picked up (in particular, with the gripping step of the handling method), during which the support structure 4 is operated to move the vacuum gripping device 5 gripping the article 3 from a first position, for example in the case illustrated in Figures from 1 to 4 from a first position at the support 17, to a second position, different from the first position, for example in the case illustrated in Figures from 1 to 5 at a storage bench 25 at vacuum depression.

According to some advantageous but not limiting embodiments, the control method of the handling system 1 also provides for moving the vacuum gripping device 5 with the gripped article 3 from a first position to a second position, different from the first position, by means of the support structure 4 (in particular, by moving the support structure 4 in space).

Advantageously but not limitingly, the control method of the handling system 1 comprises, furthermore, a step of detecting the position of the article 3 to be picked up by means of a detection system (not illustrated and known per se).

The present invention has numerous advantages, comprising the following.

The above handling method and control method, relating to the use of a handling system 1 provided with a valve unit 11 like the one described and providing for a tilting step, before the gripping step, enable for the stable and reliable picking up and handling of even articles 3 with dimensions much smaller than the extension of the gripping surface 9. In particular, it has been experimentally observed that with said method, with the same vacuum generating unit 8 and dimensions of the gripping surface 9, it is possible to safely and effectively move articles 3 that are much smaller than the articles 3 that can be handled with known handling systems; more specifically, said method enables for the handling of articles 3 with dimensions equal to approximately 1/3 (one third) of the dimensions of the smallest articles 3 that can be picked up with standard handling methods (always with the same vacuum generating unit 8 and dimensions of the gripping surface 9). In detail, the methods of the present invention enable the effective and safe handling of articles with dimensions equal to 30% of the size of the gripping surface 9.

Furthermore, the solution of the present invention also advantageously enables the gripping of any type of article 3 regardless of how it is oriented; more specifically, it enables to effectively pick up even articles 3 arranged inclined with respect to the horizontal direction.

Finally, the following aspects of the invention are provided.
1. A handling method for moving at least one article (3) which rests (in particular, directly or indirectly) on a substantially horizontal support plane (2) by means of a handling system (1) comprising a support structure (4) and a vacuum gripping device (5) which is made carried in a movable manner by the support structure (4) and which, in turn, comprises a suction chamber (6) provided with a plurality of first openings (7), a vacuum generating unit (8) for generating a given depression in said suction chamber (6), a gripping surface (9) intended, in use, to come into contact with the article (3) to be picked up and provided with a plurality of second openings (10), and a plurality of valve assemblies (11) operatively interposed between said suction chamber (6) and said gripping surface (9); each valve assembly (11) comprising a duct (13) extending from a respective first opening (7) to a respective second opening (10), a shutter (14) movable in the respective duct (13) between a first position, in which it closes the respective first opening (7) to prevent the fluidic connection between the respective duct (13) and said suction chamber (6), and a second position, in which it disengages, at least partially, said first opening (7) to enable the fluidic connection between the respective duct (13) and said suction chamber (6), and a compensation hole (15) which establishes a fluidic connection between said duct (13) and said suction chamber (6); the handling method comprises the following steps:
   a tilting step, during which said support structure (4) rotates said vacuum depression gripping device (5) by an angle of approximately at least 90° (in particular, by an angle approximately ranging from at least 90° to approximately 180°) with respect to said support plane (2) (in particular, with respect to a horizontal plane) so that said shutter (14) shifts, by gravity, from said second position to said first position;
   an activation step, at least partially subsequent to said tilting step, during which said vacuum generating unit (8) generates said given depression inside said suction chamber so as to exert a first suction action upon the shutter element (14), through said first opening (7), so as to hold the same in said first position;
   a gripping step, during which said support structure (4) moves said vacuum depression gripping device (5) until said gripping surface (9) comes into contact with a wall of said at least one article (3) to be picked up, by occluding at least a part of said second openings (10) so as to cause the movement of the respective shutters (14) from said first position to said second position in order to transfer at least part of said first suction action to said at least one article (3) to be picked up so as to hold the same.
2. The handling method according to aspect 1, wherein: said tilting step comprises a first tilting sub-step, during which said support structure (4) moves said vacuum depression gripping device (5) from an initial configuration to a tilted configuration, in which said gripping surface (9) is arranged so as to form an angle of approximately at least 90° (in particular, of an angle ranging from approximately at least 90° to approximately 180°) with respect to said support plane (2); and, during said activation step said vacuum depression gripping device (5) is held in said tilted configuration.
3. The handling method according to aspect 2, wherein said tilting step comprises a second tilting sub-step, at least partially subsequent to the first tilting sub-step, during which said support structure (4) holds said vacuum gripping device (5) in said tilted configuration for an amount of time by approximately at least 0.5 seconds (in particular, by approximately at least 1 second; even more specifically, by approximately at least 2 seconds).
4. The handling method according to any of the preceding aspects, wherein:
   once said vacuum generating unit (8) is activated, a controlled flow of fluid (in particular, air) is established from said suction chamber (6) towards said duct (13) through said compensation hole (15);
   said gripping step comprises, in turn: a compensation sub-step, during which, once the second opening delimiting a given duct (13) is occluded by said wall of said at least one article (3) to be picked up, said controlled fluid flow continues until pressure conditions similar to those present inside the suction chamber (6) are established inside said duct (13), so that said shutter (14) is subjected to a second suction action, equal and opposite to said first suction action, and an opening sub-step, at least partially subsequent to said compensation sub-step, during which said shutter (14), subjected to a resulting action directed towards said second opening (10) shifts from said first position to said second position when.
5. The handling method according to aspect 4, wherein said shutter (14) comprises (in particular, is formed by) an element having a mass approximately greater than 0.1 g, and during said opening sub-step, said shutter (14) shifts from said first position to said second position exclusively by the effect of the force of weight to which said shutter (14) is subjected.
6. The handling method according to any one of the aspects from 1 to 4, wherein: each valve assembly (11) comprises a spring arranged in the respective duct (13) and configured to act upon said shutter (14) by transmitting an elastic force having at least one component along a direction parallel to a longitudinal axis of the respective duct (13) from said first opening (7) towards said second opening (10), and having a modulus that is smaller than the force of weight to which said shutter (14) is subjected; and during said opening sub-step said shutter (14) is pushed from said first position to said second position at least by said spring force.
7. The handling method according to any one of the preceding aspects, wherein said gripping surface (9) comprises (in particular, is formed by) an array of suction cups (19) and, during said gripping step, at least part of said suction cups (19) are pressed against said wall of said at least one article (3) to be picked up so as to transmit at least part of said first suction action and grip said at least one article (3) to be picked up.
8. The handling method according to any one of the preceding aspects, wherein said handling system (1) comprises a layer (18) made of a flexible material (in particular, having an elastic modulus approximately ranging from 0.5 N/mm² to approximately 10 N/mm²) interposed between said suction chamber (6) and said gripping surface (9); said ducts (13) of said valve assemblies (11) passing through said layer (18) of flexible material; and during said gripping step, once said gripping surface (9) has come into contact with said wall of said at least one article (3) to be picked up, said layer (18) of flexible material deforms at least partially to compensate for any roughness of said at least one wall of said at least one article (3).
9. The handling method according to any of the preceding aspects, comprising a handling step, at least partially simultaneous with said gripping step, during which said support structure (4) is operated so as to move said vacuum depression gripping device (5) gripping said at least one article (3) to be picked up from a first position to a second position, different from the first position.

## Claims

1. A control method for controlling a handling system (1) comprising a support structure (4) and a vacuum depression gripping device (5), which is carried by the support structure (4) in a movable manner and which, in turn, comprises a suction chamber (6) provided with a plurality of first openings (7), a vacuum generating unit (8) for generating a given depression in said suction chamber (6), a gripping surface (9) intended, in use, to come into contact with the article (3) to be picked up and provided with a plurality of second openings (10), and a plurality of valve assemblies (11) operatively interposed between said suction chamber (6) and said gripping surface (9); each valve assembly (11) comprising a duct (13), which extend from a respective first opening (7) to a respective second opening (10), a shutter (14) movable in the respective duct (13) between a first position, in which it closes the respective first opening (7) to prevent the fluidic connection between the respective duct (13) and said suction chamber (6), and a second position, in which it disengages, at least partially, said first opening (7) to enable the fluidic connection between the respective duct (13) and said suction chamber (6), and a compensation hole (15) which establishes a fluidic connection between said duct (13) and said suction chamber (6); the control method comprises the steps of:
rotating said vacuum depression gripping device (5) by an angle of approximately at least 90° (in particular, by an angle ranging approximately from at least 90° to approximately 180°) with respect to said support plane (2) (in particular, with respect to a horizontal plane) by operating said support structure (4) so that said shutter (14) shifts, by gravity, from said second position to said first position;
setting a given depression value (in particular, equal to at most approximately -0.1 bar; more specifically, ranging from approximately -0.1 bar to approximately -0.3 bar) in said suction chamber (6) by means of said vacuum generating unit (8) while said support structure (4) is rotated to exert a first suction action on said shutter (14) which keeps it in said first position;
bringing said gripping surface (9) into contact with a wall of said at least one article (3) to be picked up, occluding at least a part of said second openings (10) so as to cause the movement of the respective shutters (14) from said first position to said second position in order to transfer at least part of said first suction action to said at least one article (3) to be picked up so as to hold the same.

2. The control method according to claim 1, wherein: said step of rotating said vacuum depression gripping device (5) comprises a first tilting sub-step, during which said vacuum depression gripping device (5) is moved, by means of said support structure (4), from an initial configuration to a tilted configuration, wherein said gripping surface (9) is arranged so as to form an angle of approximately at least 90° (in particular, of an angle approximately ranging from at least 90° to approximately 180°) with respect to said support plane (2); and during said step of setting a given depression value, said vacuum depression gripping device (5) is held in said tilted configuration.

3. The control method according to claim 2, wherein said step of rotating said vacuum depression gripping device (5) comprises a second tilting sub-step, at least partially subsequent to the first tilting sub-step, during which said vacuum depression gripping device (5) is held in said tilted configuration for an amount of time by approximately at least 0.5 seconds (in particular, by approximately at least 1 second; even more particularly, by approximately at least 2 seconds) .

4. The control method according to any one of the preceding claims, wherein:
once said vacuum generating unit (8) is activated, during said step of setting a given depression value, a controlled flow of fluid (in particular, air) is established from said suction chamber (6) towards said duct (13) through said compensation hole (15);
said step of bringing said gripping surface (9) into contact with a wall of said at least one article (3) to be picked up comprises, in turn: a compensation sub-step, during which, once the second opening delimiting a given duct (13) is occluded by said wall of said at least one article (3) to be picked up, said controlled flow of fluid continues until pressure conditions similar to those present inside the suction chamber (6) are established inside said duct (13), so that said shutter (14) is subjected to a second suction action, equal and opposite to said first suction action, and an opening sub-step, which is at least partially subsequent to said compensation sub-step and during which said shutter (14), subjected to a resulting action directed towards said second opening (10) shifts from said first position to said second position.

5. The control method according to claim 4, wherein said shutter (14) comprises (in particular, is formed by) an element having a mass approximately greater than 0.1 g, and during said opening sub-step, said shutter (14) shifts from said first position to said second position exclusively due to the force of weight to which said shutter (14) is subjected.

6. The control method according to any one of the claims from 1 to 4, wherein: each valve assembly (11) comprises a spring arranged in the respective duct (13) and configured to act upon said shutter (14) by transmitting an elastic force having at least one component along a direction parallel to a longitudinal axis of the respective duct (13) from said first opening (7) towards said second opening (10), and having a modulus that is smaller than the force of weight to which said shutter (14) is subjected; and
during said opening sub-step said shutter (14) is pushed from said first position to said second position at least by said elastic force.

7. The control method according to any one of the preceding claims, wherein said gripping surface (9) comprises (in particular, is formed by) an array of suction cups (19) and during said step of bringing said gripping surface (9) into contact with a wall of said at least one article (3) to be picked up at least part of said suction cups (19) are pressed against said wall of said at least one article (3) to be picked up to transmit at least part of said first suction action and grip said at least one article (3) to be picked up.

8. The control method according to any one of the preceding claims, wherein said movement system (1) comprises a layer (18) of flexible material (in particular, having an elastic modulus approximately ranging from 0.5 N/mm² to approximately 10 N/mm²) interposed between said suction chamber (6) and said gripping surface (9); said ducts (13) of said valve assemblies (11) passing through said layer (18) of flexible material; and, during said step of bringing said gripping surface (9) into contact with a wall of said at least one article (3) to be picked up, once said gripping surface (9) has come into contact with said wall of said at least one article (3) to be picked up, said layer (18) of flexible material deforms at least partially to compensate for any roughness of said at least one wall of said at least one article (3).

9. The control method according to any one of the preceding claims, comprising a step of moving said vacuum depression gripping device (5) holding said at least one article (3) to be picked up from a first position to a second position, different from the first position, by means of said support structure (4) (in particular, by moving said support structure in space).
